# EUROPEAN PATENT SPECIFICATION

(11) **EP 2 413 681 B1**
(45) Date of publication and mention of the grant of the patent: **23.10.2013**
(21) Application number: 11165532.0
(22) Date of filing: 10.05.2011
(51) Int. Cl.: H05K 7/20

(54) **Separate cooling plate for aircraft engine electric control**
Separate Kühltafel für eine Flugzeugmotor-Elektrosteuerung
Plaque de refroidissement séparée pour commande électrique de moteur d'avion

(30) Priority: 10.05.2010 US 776666
(43) Date of publication of application: 01.02.2012
(73) Proprietor: Hamilton Sundstrand Corporation, Windsor Locks, CT 06096-1010 (US)
(72) Inventor: Poisson, Richard A., Avon, CT 06001 (US)
(74) Representative: Tomlinson, Kerry John

(56) References cited:
- US-A1- 2008 010 994

## Description

### BACKGROUND

This application relates to a cooling plate for an aircraft electric control, wherein the cooling plate is maintained separate from the control.

Aircraft engines are provided with many complex controls in modern aircraft. The engine is typically provided with an electric control that controls most aspects of the aircraft, and is known as a full authority digital engine control, or "FADEC."

Many electric controls become quite hot during operation, and the FADEC is no exception. As such, FADECs have typically been constructed with an internal cooling circuit. A cooling fluid is circulated through the cooling circuit, and within the FADEC. Often, aircraft fuel is circulated through the cooling plate as a cooling fluid. The use of an internal cooling fluid has also been utilized for other types of electric controls mounted directly to an engine housing.

Separate cooling plates have been known for electric controls, but they have not been utilized with a FADEC, nor with an electric control which is mounted to an engine housing.

However, by having the cooling fluid circulate within the electric control, there are concerns raised with regard to leakage of fluid in the control.

US 2008/0010994 discloses the pre-characterizing portion of claim 1.

### SUMMARY

The present invention provides a gas turbine engine comprising: an outer housing; operational components to combust a fuel and provide energy; an electrical element; and a cooling plate, said cooling plate including internal fluid passages for circulating a cooling fluid, and providing cooling to said electrical element, and said cooling plate being attached to an outer surface of said outer housing; said electrical element being attached to said cooling plate; said internal fluid passages being positioned to be on a face of said cooling plate which is spaced toward a face of said electrical element in contact said cooling plate; said electrical control being a full authority digital engine control; and said full authority digital engine control being operable to control at least fuel flow, vane position, and the operation of valves associated with said gas turbine engine, and characterised in that said cooling plate is provided with a plurality of legs to receive securing members for securing said cooling plate to said outer housing; and said electrical element is provided with legs on opposed sides of an electric element body, and said legs being provided with openings aligned with openings in said cooling plate to secure said electrical element to said cooling plate.

These and other features of the present invention can be best understood from the following specification and drawings, the following of which is a brief description.

### BRIEF DESCRIPTION OF THE DRAWINGS

Figure 1 is a cross-sectional view through an inventive arrangement.
Figure 2 schematically shows a cooling plate fluid flow.
Figure 3 shows the structure of Figure 1 disassembled.
Figure 4 shows a detail of the cooling plate.
Figure 5 shows a detail of the FADEC.

### DETAILED DESCRIPTION

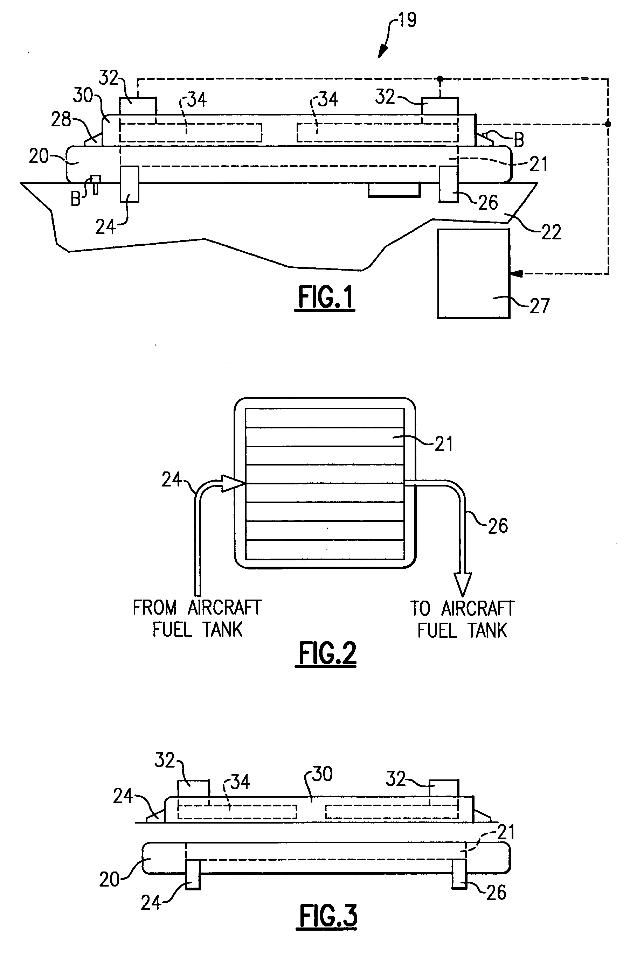

An assembly 19 is illustrated in Figure 1 incorporating a full authority digital engine control (FADEC 30), which is an electrical control unit, and a cooling plate 20. The cooling plate 20 is provided with internal fluid passages forming an internal cooling circuit 21 having fluid connections 24 and 26 for circulating a cooling fluid and providing cooling to the FADEC 30. The cooling plate 20 is attached to the outer surface of an engine housing 22, which may be a gas turbine engine mounted in an aircraft controlled by the FADEC 30.

The FADEC 30 is attached to the outer surface of the cooling plate 20. Side legs 28 of the FADEC 30 are also shown in Figure 1. The FADEC is a self-contained unit and the cooling plate 20 is separate from the FADEC.

Electrical connectors 32 connect electric circuit elements 34 within the FADEC 30, and as shown by phantom line, to and from operational components 27 in the aircraft engine. The pair of electric circuit elements 34 depicted in Figure 1 may represent electric circuits for separate channels of operation, which can be configured as a shared control (active/active) or a redundant control (active/standby). Distributing the electric circuit elements 34 in a planar manner across the FADEC 30 spreads the heat load over the surface of the cooling plate 20.

As known, a FADEC is an electrical control programmed to control any number of operational systems on the aircraft engine. Among the operational components 27 which are controlled by the FADEC 30 would be the fuel flow system, stator vane positions for variable vanes associated with the gas turbine engine compressor, bleed valve positions, and a number of other valve positions. The FADEC 30 is also operable to control engine starting and restarting. For purposes of this application, the FADEC 30 may be taken as known, and the invention would extend to any number of variations on the basic structure as outlined above.

The FADEC 30 receives multiple inputs, such as from the aircraft, which may include air density, throttle lever position, engine temperatures, engine pressures, and many other parameters. All of these inputs are utilized to control the operational components 27 to achieve desired engine characteristics, again as known.

As shown in Figure 2, the cooling circuit 21 takes in fluid from inlet 24, and delivers it outwardly of outlet 26. The fluid may be circulated from an aircraft fuel tank, as known.

Figure 3 shows the disassembly of the FADEC 30 from the cooling plate 20, illustrating that the FADEC 30 is physically separate and separable from the cooling plate 20. As can be appreciated, the cooling circuit 21 is positioned on an outer face of the cooling plate 20 such that it is to provide efficient and adequate cooling to the FADEC 30.

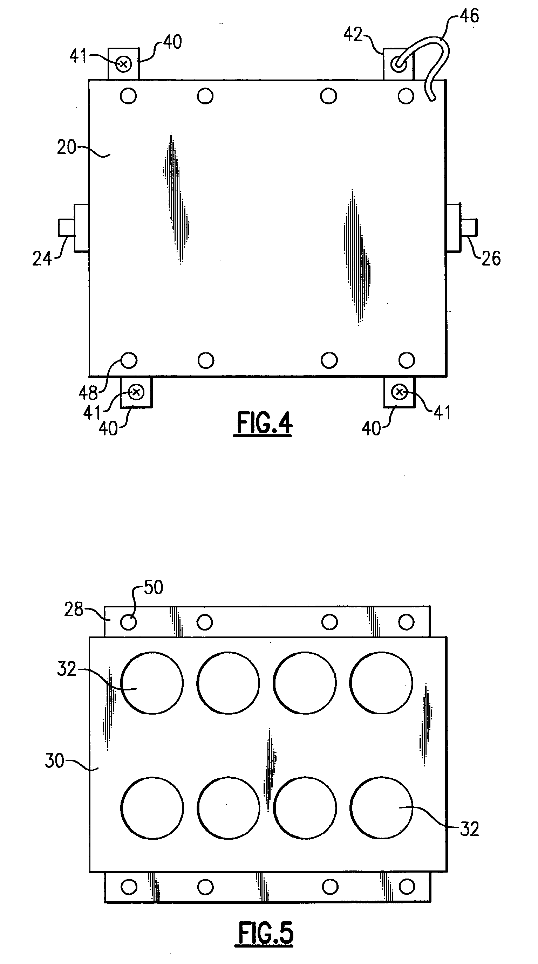

As shown in Figure 4, the cooling plate 20 has the inlet 24, outlet 26, and a plurality of bolt legs 40. One of the bolt legs 40, shown at 42, receives a ground strap 46. The ground strap 46 is utilized to provide a ground for the FADEC 30.

The bolt legs 40 are secured to the outer surface of the engine housing 22, by receiving securing members such as bolts.

The FADEC 30 is illustrated in Figure 5. As shown, the side legs 28 have a plurality of bolt holes 50, which are aligned with holes 48 in the cooling plate 20. As can be appreciated, the FADEC 30 is secured to the cooling plate 20 through bolts extending through holes 50 and into threaded openings of holes 48.

The cooling plate 20 may be provided with vibration isolators 41, shown schematically in Figure 4. Vibration isolators are known, and are currently utilized to attach a FADEC directly to the engine housing 22. Further, as shown schematically in Figure 1, bolts B secure the cooling plate 20 to the engine housing 22, and secure the FADEC 30 to the cooling plate 20.

While this application specifically discloses a FADEC mounted directly to an engine housing, it should be understood that it could apply to a FADEC mounted elsewhere. In addition, it would extend to electric controls that are distinct from being a full FADEC control, but which are mounted to an outer engine housing with an intermediate cooling plate. In fact, this feature would extend to other engine mounted electric elements beyond controls, including sensors, for example.

Although an embodiment of this invention has been disclosed, a worker of ordinary skill in this art would recognize that certain modifications would come within the scope of this invention. For that reason, the following claims should be studied to determine the true scope and content of this invention.

## Claims

1. A gas turbine engine comprising:
an outer housing (22);
operational components (27) to combust a fuel and provide energy;
an electrical element (30); and
a cooling plate (20),
said cooling plate including internal fluid passages for circulating a cooling fluid, and providing cooling to said electrical element, and said cooling plate being attached to an outer surface of said outer housing;
said electrical element being attached to said cooling plate;
said internal fluid passages being positioned to be on a face of said cooling plate which is spaced toward a face of said electrical element in contact said cooling plate;
said electrical element being a full authority digital engine control; and
said full authority digital engine control being operable to control at least fuel flow, vane position, and the operation of valves associated with said gas turbine engine,
and **characterised in that** said cooling plate is provided with a plurality of legs (40) to receive securing members (41) for securing said cooling plate to said outer housing; and
said electrical element is provided with legs on opposed sides of an electric element body, and said legs being provided with openings (50) aligned with openings (48) in said cooling plate to secure said electrical element to said cooling plate.

## Patentansprüche

1. Gasturbinenmaschine, aufweisend:
ein äußeres Gehäuse (22) ;
Betriebskomponenten (27) zum Verbrennen eines Brennstoffs und zum Bereitstellen von Energie;
ein elektrisches Element (30); und
eine Kühlplatte (20),
wobei die Kühlplatte interne Fluidpassagen für die Zirkulation eines Kühlfluids sowie zum Schaffen von Kühlung für das elektrische Element aufweist und wobei die Kühlplatte an einer Außenfläche des äußeren Gehäuses befestigt ist;
wobei das elektrische Element an der Kühlplatte befestigt ist;
wobei die internen Fluidpassagen auf einer Seite der Kühlplatte positioniert sind, die zu einer Seite des elektrischen Elements versetzt ist, das mit der Kühlplatte in Berührung steht;
wobei es sich bei dem elektrischen Element um eine vollelektronische digitale Maschinensteuerung handelt; und
wobei die die vollelektronische digitale Maschinensteuerung betriebsmäßig dazu ausgebildet ist, zumindest die Brennstoffströmung, die Leitschaufelposition und den Betrieb von Ventilen zu steuern, die der Gasturbinenmaschine zugeordnet sind,
**dadurch gekennzeichnet, dass** die Kühlplatte mit einer Mehrzahl von Füßen (40) zum Aufnehmen von Befestigungselementen (41) versehen ist, um die Kühlplatte an dem äußeren Gehäuse zu befestigen; und
dass das elektrische Element auf gegenüberliegenden Seiten eines Körpers des elektrischen Elements mit Füßen versehen ist, die mit Öffnungen (50) versehen sind, die mit Öffnungen (48) in der Kühlplatte ausgerichtet sind, um das elektrische Element an der Kühlplatte zu befestigen.

## Revendications

1. Moteur à turbine à gaz, comprenant :
un logement externe (22) ;
des composants opérationnels (27) pour brûler un carburant et fournir de l'énergie ;
un élément électrique (30) ; et
une plaque de refroidissement (20),
ladite plaque de refroidissement comprenant des passages à fluide internes pour faire circuler un fluide de refroidissement et assurer le refroidissement dudit élément électrique, ladite plaque de refroidissement étant fixée à une surface externe dudit logement externe ;
ledit élément électrique étant fixé à ladite plaque de refroidissement ;
lesdits passages à fluide internes étant positionnés pour se situer sur une face de ladite plaque de refroidissement qui est espacée d'une face dudit élément électrique en contact avec ladite plaque de refroidissement ;
ledit élément électrique étant une commande de moteur numérique de pleine autorité ; et
ladite commande de moteur numérique de pleine autorité étant à même de commander au moins un écoulement de carburant, une position d'aube et le fonctionnement de soupapes associées audit moteur à turbine à gaz,
et **caractérisé en ce que** ladite plaque de refroidissement est pourvue d'une pluralité de jambes (40) pour recevoir des éléments de fixation (41) afin de fixer ladite plaque de refroidissement audit logement externe ; et
ledit élément électrique est pourvu de jambes sur les côtés opposés d'un corps d'élément électrique et lesdites jambes sont pourvues d'ouvertures (50) alignées sur des ouvertures (48) de ladite plaque de refroidissement pour fixer ledit élément électrique à ladite plaque de refroidissement.
